# EUROPEAN PATENT APPLICATION

(11) **EP 4 617 677 A1**
(43) Date of publication of application: **17.09.2025**
(21) Application number: 23888954.7
(22) Date of filing: 16.10.2023
(51) Int. Cl.: G01R 15/18, H01F 27/40, H01F 1/34, H01F 1/153

(54) **PASSIVE LOW-POWER CURRENT TRANSFORMER FOR CIRCUIT BREAKER HAVING WIDE CURRENT MEASUREMENT RANGE AND SYSTEM LINEARITY**

(30) Priority: 07.11.2022 KR 20220147051
(71) Applicant: Hyosung Heavy Industries Corporation, Seoul 04144 (KR)
(72) Inventor: KIM, Jong Wang, Anyang-si Gyeonggi-do 14067 (KR); KIM, Do Jin, Changwon-si Gyeongsangnam-do 51526 (KR); PARK, Joung Hu, Seoul 06975 (KR); LEE, Chun Gu, Hanam-si Gyeonggi-do 13017 (KR)
(74) Representative: Viering, Jentschura & Partner mbB Patent- und Rechtsanwälte
(86) International application number: PCT/KR2023/015911
(87) International publication number: WO 2024/101691

(57) **Abstract**

A passive-type low-power current transformer (LPCT) for a circuit breaker with a wide current measurement range and system linearity in accordance with the present invention comprises: a Rogowski coil installed around a power line to measure a current of the power line; a signal-amplifying transformer made of a high permeability material and connected with the Rogowski coil to amplify a low output signal outputted from the Rogowski coil; and a passive integrator for integrating in a time domain and outputting a signal outputted from the signal-amplifying transformer.

In accordance with the present invention, a signal-amplifying transformer made of high permeability with high magnetizing inductance can be used to secure system linearity and amplify a low output signal to have a wide current measurement range, and it can be installed enough in places with spatial constraints such as Gas Insulated Switchgear (GIS) .

## Description

### FIELD OF THE INVENTION

The present invention relates to a low-power current transformer (LPCT) to measure current, and more particularly, to the LPCT installed in a circuit breaker.

### BACKGROUND OF THE INVENTION

In the past, substations used a simple communication method of transmitting one-to-one signals by physical electric cables to monitor electric power equipment required for the process of electric power transmission, but modern substations are operated with a digital system that considers all signals for monitoring and controlling electric power equipment as sharable data.

Since it is the most important for such digitalized substations to be capable of sharing data between devices through a network, most of power generation companies and producers around the world have built such systems based on international standards such as IEC 61850. As an internationally recognized communication standard protocol provided by the International Electrotechnical Commission (IEC), IEC 61850 provides generally applied rules for communications between medium-voltage devices and high-voltage switchgears and defines required system requirements.

Meanwhile, even power systems have become larger and ultra-highly pressurized due to the rapid growth in electricity demand caused by the development of industries. Accordingly, the stabilization and reliability of power facilities have become very important issues. The extra-high voltage substation facilities due to rapid growth in such electricity demand have developed from existing gas or oil insulated substation facilities to gas insulated ones.

In general, a circuit breaker installed to a power system plays a role in protecting the power system stably. Particularly, a Gas Insulated Switchgear (GIS) is a device installed on a transmission or distribution line to protect the power system safely by opening and closing the line not only under normal conditions but also under abnormal conditions such as ground fault or short circuit.

A current sensor such as current transformer to measure operating current or fault current is installed to operate such circuit breaker and control its operation. In the past, low-power current transformers (LPCTs), which active components such as operational amplifier (OP-AMP) to amplify low output signals were applied to, have been used.

For instance, Korean Laid-Open Patent No. 10-2008-0104678 discloses a configuration for amplifyinging an output signal of a current detector installed in a circuit breaker in response to a preset gain by using an OP-AMP.

Meanwhile, passive-type LPCTs have an advantage of no power supply required compared to active-type LPCTs and they have a cost-saving effect because they do not require any active components such as OP-AMP.

However, a Rogowski coil used in a passive-type LPCT was difficult to increase a low output signal, and also to measure a wide range of current and secure system linearity because it cannot use active-type amplifiers such as OP-AMPs due to spatial constraints in that it should be installed in a narrow space within a GIS.

As a method for amplifyinging an output signal from the Rogowski coil without any active-type amplifier, there is a method of using a transformer, but due to large size, saturation, and linearity problems, the conventional transformers had limitations in improving the current measurement range.

### DETAILED EXPLANATION OF THE INVENTION

### OBJECTS OF THE INVENTION

The object of the present invention is to provide a passive-type low-power current transformer (LPCT) for a circuit breaker that has a wide current measurement range by using a signal-amplifying transformer made of a high permeability material with high magnetizing inductance and thereby amplifying a low output signal while securing system linearity to solve such problem.

The other object of the present invention is to provide a passive-type LPCT for a circuit breaker that can be installed enough even in places with spatial constraints such as Gas Insulated Switchgear (GIS) while securing a wide current measurement range and system linearity.

### MEANS OF SOLVING THE PROBLEM

A passive-type low-power current transformer (LPCT) for a circuit breaker with a wide current measurement range and system linearity in accordance with one example embodiment of the present invention may comprise: a Rogowski coil installed around a power line to measure a current of the power line; a signal-amplifying transformer made of a high permeability material and connected with the Rogowski coil to amplify a low output signal outputted from the Rogowski coil; and a passive integrator for integrating in a time domain and outputting a signal outputted from the signal-amplifying transformer.

At the time, bandwidth design and gain design for signal amplification are made for a passive board including the passive integrator whose bandwidth is set to have a low frequency domain and a commercial frequency band that satisfy 5TPE.

Meanwhile, the signal-amplifying transformer may be made of a high permeability material with initial permeability of at least 30,000.

Besides, the signal-amplifying transformer may be set to have a high magnetizing inductance with an impedance higher by 100 or more times compared to the impedance of the Rogowski coil.

At the time, the high permeability material used for the signal-amplifying transformer may be one of nanocrystalline, ferrite, and amorphous.

### EFFECTS OF THE INVENTION

A passive-type low-power current transformer (LPCT) for a circuit breaker with a wide current measurement range and system linearity in accordance with the present invention has an effect of having a wide current measurement range by using a signal-amplifying transformer made of a high permeability material with high magnetizing inductance and thereby amplifying a low output signal while securing system linearity.

In addition, the passive-type LPCT for a circuit breaker with a wide current measurement range and system linearity in accordance with the present invention has the other effect of being installable enough even in places with spatial constraints such as Gas Insulated Switchgear (GIS) while securing a wide current measurement range and system linearity.

### BRIEF DESCRIPTION OF THE DRAWINGS

Fig. 1 is a drawing representing a passive-type low-power current transformer (LPCT) for a circuit breaker with a wide current measurement range and system linearity and its equivalent circuit in accordance with one example embodiment of the present invention.
Fig. 2 is a configuration diagram to explain a signal-amplifying transformer in Fig. 1.
Fig. 3 is a drawing to explain an equivalent circuit of a Rogowski coil and a signal-amplifying transformer in Fig. 1 and its operation.

### DETAILED DESCRIPTION OF THE PREFERRED EMBODIMENTS

The specific example embodiments of the present invention are explained by referring to attached drawings below.

Upon the explanation of the present invention, terms such as "first," "second," etc. may be used to explain a variety of components but the components may not be limited by such terms. The terms are used only for the purpose of distinguishing one component from another. For example, a first component may be named as a second component without being beyond the scope of the rights of the present invention and similarly, even a second component may be named as a first one.

If it is mentioned that a component is connected or linked to another component, it may be understood that the component may be directly connected or linked to the another component but also a third component may exist in between them.

The terms used in this specification are used only to explain specific examples of embodiments and they are not intended to limit the present invention. Unless a context clearly indicates a different meaning, any reference to singular may include plural ones.

In this specification, terms such as include or equip are used to indicate that there are features, numbers, steps, operations, components, parts, or combinations thereof, and it can be understood that existence or one or more different features, numbers, steps, operations, components, parts, or combinations thereof are not precluded.

Besides, for clearer explanation, shapes, sizes, etc. of elements in drawings may be exaggerated.

By referring to drawings attached below, a passive-type low-power current transformer (LPCT) in accordance with the present invention is explained in more detail.

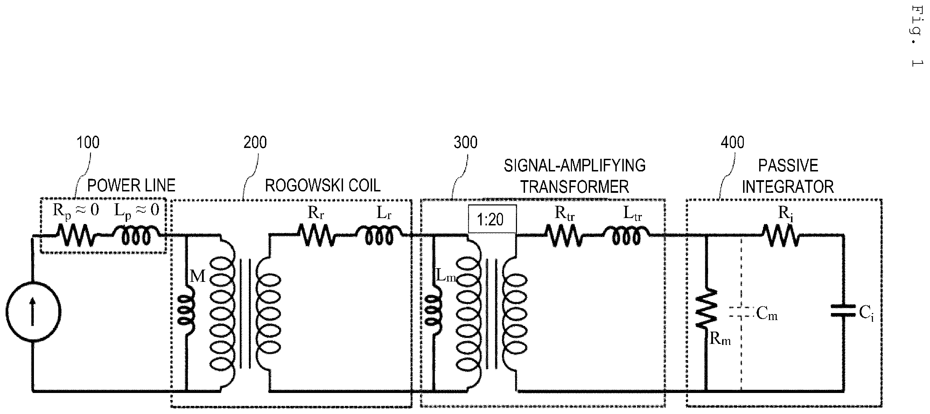

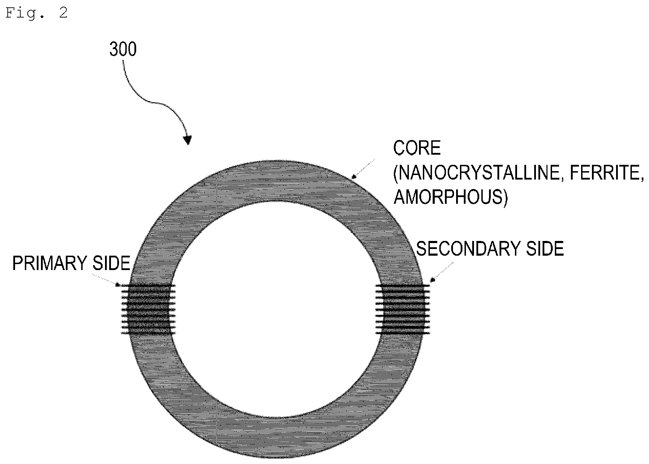

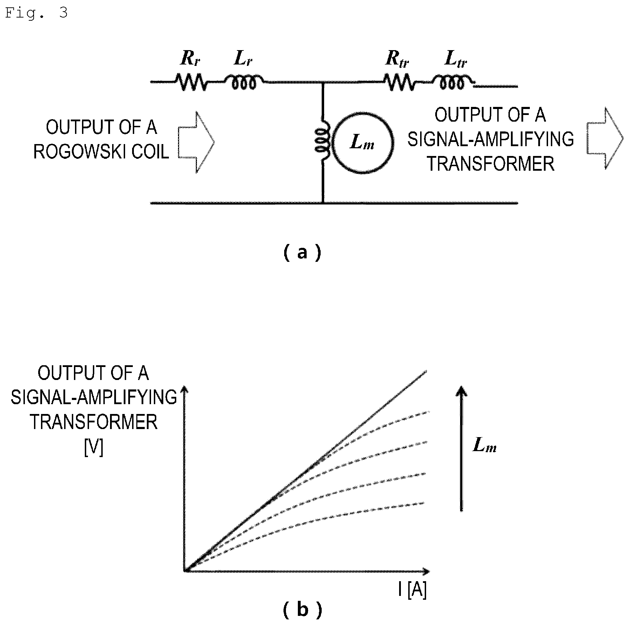

Fig. 1 is a drawing representing a passive-type LPCT for a circuit breaker with a wide current measurement range and system linearity and its equivalent circuit in accordance with one example embodiment of the present invention, and Figs. 2 and 3 are detailed drawings to explain Fig. 1 in more detail.

First of all, as can be known from Fig. 1, a passive-type LPCT for a circuit breaker with a wide current measurement range and system linearity in accordance with the present invention comprises: a Rogowski coil 200 installed around a power line 100 to measure a current of the power line 100; a signal-amplifying transformer 300 made of a high permeability material for amplifying a low output signal outputted from the Rogowski coil 200 by being connected with the Rogowski coil 200; and a passive integrator 400 for integrating in a time domain and outputting a signal outputted from the signal-amplifying transformer 300.

In Fig. 1, Rₚ and Lₚ in the power line mean resistance and inductance of the power line, respectively; and Rᵣ, Lᵣ, and M mean resistance, inductance, and magnetizing inductance of the Rogowski coil, respectively. In addition, Rₜᵣ, Lₜᵣ, and Lₘ in the signal-amplifying transformer represent resistance, inductance, and magnetizing inductance of the signal-amplifying transformer, respectively; and Rᵢ, Cᵢ, Rₘ, and Cₘ in the passive integrator mean resistance, capacitance, magnetizing resistance, and parasitic capacitance of the passive integrator, respectively.

As the Rogowski coil can be the same as that commonly used in a current transformer for measuring current of a power line, and its structure and functions have been already disclosed, detailed explanation is omitted.

In accordance with the present invention, a low output signal of the Rogowski coil 200 is amplified by the signal-amplifying transformer 300 made of a high permeability material, and then it is outputted through the passive integrator 400. Fig. 1 showed a case of setting the amplification ratio of the signal-amplifying transformer to 1:20 as one example, but the present invention is not limited to this, which may be set differently depending on the needs.

In accordance with the present invention, this may allow the passive integrator 400 to secure the linearity and signal amplification effect. Since no active component such as operational amplifier (OP-AMP) is used, no separate power supply is required and this may bring a cost reduction effect.

Meanwhile, bandwidth design and gain design for signal amplification may be made for a passive board including the passive integrator to measure a wide range of current in accordance with the present invention. For instance, it is desirable to make the bandwidth of the passive board have a low frequency domain and a commercial frequency band that satisfy 5TPE. Herein, 5TPE means an accuracy class of metering for a current transformer.

At this time, as the passive integrator 400 can be the same as that commonly used, and its structure and functions have been already disclosed, detailed explanation is omitted.

Next, detailed explanation is made on a signal-amplifying transformer 300 in accordance with the present invention by referring to Fig. 2. Fig. 2 is a configuration diagram to explain a signal-amplifying transformer 300 in Fig. 1.

As can be seen in Fig. 2, the signal-amplifying transformer 300 in accordance with the present invention may use a toroidal transformer with a circular core.

The core of the signal-amplifying transformer 300 in accordance with the present invention is made of a high permeability material with initial permeability of at least 30,000, and it is formed to have high magnetizing inductance with impedance higher by 100 or more times compared to the impedance of a Rogowski coil.

The high permeability materials used for the core of the signal-amplifying transformer 300 in accordance with the present invention may include nanocrystalline, ferrite, amorphous, etc.

In accordance with the present invention, the linearity and signal amplification effect may be secured by using the signal-amplifying transformer made of such high permeability material.

Fig. 3 explains the linearity and signal amplification effect that the signal-amplifying transformer made of such high permeability material in accordance with the present invention. Fig. 3 is a drawing to explain an equivalent circuit of a Rogowski coil and a signal-amplifying transformer in Fig. 1 and its operation.

In Fig. 3, (a) represents an equivalent circuit of a Rogowski coil 200 and a signal-amplifying transformer 300 in Fig. 1, and (b) is a graph to explain how the output V of the signal-amplifying transformer 300 against the output I of the Rogowski coil 200 is changed depending on permeability Lₘ of the signal-amplifying transformer 300.

In Fig. 3, Rᵣ and Lᵣ mean resistance and inductance of the Rogowski coil 200, respectively; and Rₜᵣ, Lₜᵣ, and Lₘ mean resistance, inductance, and magnetizing inductance of the signal-amplifying transformer 300, respectively.

As can be seen in Fig. 3, it can be found out that when permeability Lₘ of the signal-amplifying transformer 300 increases, the linearity of the corresponding output V of the signal-amplifying transformer is improved.

Accordingly, the signal-amplifying transformer 300 made of a high permeability material in accordance with the present invention can secure linearity with the signal amplification effect. Nanocrystalline, ferrite, amorphous, etc. may be applied as such high permeability materials.

According to the passive-type LPCT for a circuit breaker with a wide current measurement range and system linearity in accordance with the present invention as explained above, the present invention has a wide current measurement range by using a signal-amplifying transformer made of a high permeability material with high magnetizing inductance and thereby amplifying a low output signal while securing system linearity. In addition, it can be installed enough even in places with spatial constraints such as Gas Insulated Switchgear (GIS) while securing a wide current measurement range and system linearity.

What has been mentioned above includes one or more example embodiments. Of course, it may be recognized that they cannot describe all possible combinations of components or methods for the purpose of explaining afore-mentioned example embodiments but they may be added or replaced with a lot of additional combinations of various example embodiments by those skilled in the art. Accordingly, the explained example embodiments include all alternatives, modifications, and alternations within the intention and scope of what is claimed as attached below.

### Industrial Availability

The present invention relates to a low-power current transformer (LPCT) to measure current, and it is available in a field of current transformers.

## Claims

1. A passive-type low-power current transformer (LPCT) for a circuit breaker with a wide current measurement range and system linearity as a LPCT installed in a circuit breaker, comprising:
a Rogowski coil installed around a power line to measure a current of the power line;
a signal-amplifying transformer made of a high permeability material and connected with the Rogowski coil to amplify a low output signal outputted from the Rogowski coil; and
a passive integrator for integrating in a time domain and outputting a signal outputted from the signal-amplifying transformer.

2. The LPCT of Claim 1, wherein bandwidth design and gain design for signal amplification are made for a passive board including a passive integrator whose bandwidth is set to have a low frequency domain and a commercial frequency band that satisfy 5TPE.

3. The LPCT of Claim 1, wherein the signal-amplifying transformer is made of a high permeability material with initial permeability of at least 30,000.

4. The LPCT of Claim 1, wherein the signal-amplifying transformer has a high magnetizing inductance with an impedance higher by 100 or more times compared to the impedance of the Rogowski coil.

5. The LPCT of Claim 3, wherein the high permeability material used for the signal-amplifying transformer is one of nanocrystalline, ferrite, and amorphous.
